# EUROPEAN PATENT APPLICATION

(11) **EP 4 560 781 A1**
(43) Date of publication of application: **28.05.2025**
(21) Application number: 23868497.1
(22) Date of filing: 14.09.2023
(51) Int. Cl.: H01M 10/48, H01M 50/569, H01M 50/271, H01M 50/249, H01M 10/42, H01M 50/574, G01R 31/12, H01M 10/6561, H01M 10/6566

(54) **BATTERY PACK AND VEHICLE COMPRISING SAME**

(30) Priority: 19.09.2022 KR 20220118218
(71) Applicant: LG Energy Solution, Ltd., Seoul 07335 (KR)
(72) Inventor: NOH, Tae Heon, Daejeon 34122 (KR)
(74) Representative: Plasseraud IP
(86) International application number: PCT/KR2023/013845
(87) International publication number: WO 2024/063443

(57) **Abstract**

A battery pack of the present invention includes: a battery module; a pack housing provided with a pack case, in which the battery module is accommodated, and a pack cover configured to open and close the pack case; and a dew condensation detection sensor configured to detect dew condensation through an insulation abnormality signal generated inside the pack case, wherein the dew condensation detection sensor includes a first conductor and a second conductor connected to each other by the dew condensation generated inside the pack case to generate the insulation abnormality signal.

## Description

### TECHNICAL FIELD

### CROSS-REFERENCE TO RELATED APPLICATION

The present application claims the benefit of the priority of Korean Patent Application No. 10-2022-0118218, filed on September 19, 2022, which is hereby incorporated by reference in its entirety.

### TECHNICAL FIELD

The present invention relates to a battery pack having a structure capable of detecting dew condensation generated inside a pack case, and a vehicle including the same.

### BACKGROUND ART

In general, chargeable and dischargeable secondary batteries may be divided into pouch-type, prismatic, and cylindrical types depending on their structure.

The pouch-type secondary battery has a structure including an electrode assembly and a pouch accommodating the electrode assembly. The prismatic secondary battery has a structure including an electrode assembly, a can accommodating the electrode assembly, and a top cap coupled to an opening of the can. The cylindrical secondary battery has a structure including an electrode assembly, a can accommodating the electrode assembly, and a cap assembly coupled to an opening of the can.

Electric vehicles (EV) and hybrid electric vehicles (HEV) are being developed as a method for solving air pollution from existing gasoline and diesel vehicles. The electric vehicles (EV) and hybrid electric vehicles (HEV) use medium-to-large battery modules or medium-to-large battery packs in which multiple secondary batteries are electrically connected as energy sources.

The battery module has a structure that connects a plurality of secondary batteries in series and/or in parallel, and the battery pack has a structure in which one or more battery modules are embedded into a pack case.

However, the battery pack has a problem with dew condensation generated inside the pack case under high temperature and humidity environments or when there is a large temperature difference between the inside and outside of the pack case to cause corrosion of the pack case and electrolyte leakage due to cracks in the corroding portion of the pack case, thereby causing a ground fault.

### DISCLOSURE OF THE INVENTION

### TECHNICAL PROBLEM

An object of the present invention is to provide a battery pack, which includes a dew condensation detection sensor that detects dew condensation generated inside a pack case to quickly detect the dew condensation generated inside the pack case, thereby preventing an occurrence of danger at an early stage, and a vehicle including the same.

Another object of the present invention is to provide a battery pack, which includes a dew condensation removing device that removes dew condensation generated inside a pack case to effectively remove the dew condensation generated inside the pack case, thereby preventing an occurrence of danger at an early stage, and a vehicle including the same.

### TECHNICAL SOLUTION

A battery pack of the present invention may include: a battery module; a pack housing provided with a pack case, in which the battery module is accommodated, and a pack cover configured to open and close the pack case; and a dew condensation detection sensor configured to detect dew condensation through an insulation abnormality signal generated inside the pack case, wherein the dew condensation detection sensor includes a first conductor and a second conductor connected to each other by the dew condensation generated inside the pack case to generate the insulation abnormality signal.

The first conductor may include a first body connected to a voltage line of the battery module and a plurality of first terminals protruding from the first body, and the second conductor may include a second body connected to a ground of the pack case and a plurality of second terminals protruding from the second body, wherein the plurality of first terminals and the plurality of second terminals may be alternately disposed and connected to each other by the dew condensation to generate the insulation abnormality signal.

The dew condensation detection sensor may be attached to a surface of the pack cover corresponding to a top surface of the battery module.

The battery module may be provided in plurality, the pack case may include: a partition wall configured to partition an accommodation space in which the plurality of battery modules are accommodated; and a support member provided on the partition wall to support the pack cover, and the dew condensation detection sensor may be attached to a surface of the pack cover, which is close to the support member.

A power cutoff device (manual service disconnect (MSD)) that cuts off power connected to the battery module may be provided inside the pack case, and the dew condensation detection sensor may be attached to a surface of the pack cover, which is close to the power cutoff device.

The dew condensation detection sensor may be attached to the pack cover using an adhesive or an adhesive film.

The battery pack may further include a dew condensation removing device configured to circulate air inside the pack case so as to remove the dew condensation generated inside the pack case.

The dew condensation removing device may include: an injection tube and a discharge tube, which are connected to the inside of the pack case; and an air generation part configured to inject air into the pack case so as to discharge the air inside the pack case through the discharge tube.

The dew condensation removing device may include: a valve configured to open and close the injection tube and the discharge tube; and a control part configured to open the valve only when the insulation abnormality signal is generated by the dew condensation detection sensor and discharge the air inside the pack case through the air generation part.

The dew condensation removing device may further include a filter configured to filter foreign substances contained in the air passing through the injection tube.

Each of the first conductor and the second conductor may be made of copper or aluminum.

A vehicle of the present invention may include a battery pack including: a battery module; a pack housing provided with a pack case, in which the battery module is accommodated, and a pack cover configured to open and close the pack case; and a dew condensation detection sensor configured to detect dew condensation through an insulation abnormality signal generated inside the pack case, wherein the dew condensation detection sensor includes a first conductor and a second conductor connected to each other by the dew condensation generated inside the pack case to generate the insulation abnormality signal.

### ADVANTAGEOUS EFFECTS

The battery pack of the present invention may include the dew condensation detection sensor that detects the dew condensation through an insulation abnormality signal generated inside the pack case, and the dew condensation detection sensor may include the first conductor and the first conductor, which are connected by the dew condensation to generate the insulation abnormality signal. Due to these features, the dew condensation generated inside the pack case may be quickly detected, and as a result, the occurrence of the danger may be prevented at the early stage.

That is, in the battery pack of the present invention, the dew condensation detection sensor may be provided at the position corresponding to the top surface of the battery module, the position close to the support member supporting the pack cover, and the position close to the power cutoff device to quickly detect the dew condensation generated inside the pack case.

In addition, the battery pack of the present invention may be characterized by including the dew condensation removing device that removes the dew condensation generated inside the pack case. Due to this feature, the dew condensation generated inside the pack case may be quickly removed, and as a result, the safety may be improved by preventing the occurrence of danger at the early stage.

### BRIEF DESCRIPTION OF THE DRAWINGS

FIG. 1 is a perspective view of a battery back according to a first embodiment of the present invention.
FIG. 2 is a cross-sectional view of FIG. 1.
FIG. 3 is a schematic plan view illustrating the battery pack of FIG. 1.
FIG. 4 is a perspective view illustrating a support member of FIG. 1.
FIG. 5 is a plan view illustrating a dew condensation detection sensor of FIG. 1.
FIG. 6 is a cross-sectional view illustrating a dew condensation removing device of the battery pack according to the first embodiment of the present invention.
FIG. 7 is a side view of a vehicle according to a second embodiment of the present invention.

### MODE FOR CARRYING OUT THE INVENTION

Hereinafter, embodiments of the present invention will be described in detail with reference to the accompanying drawings in such a manner that the technical idea of the present invention may easily be carried out by a person with ordinary skill in the art to which the invention pertains. The present invention may, however, be embodied in different forms and should not be construed as limited to the embodiments set forth herein. In the drawings, anything unnecessary for describing the present invention will be omitted for clarity, and also like reference numerals in the drawings denote like elements.

### [Battery pack according to first embodiment of the present invention]

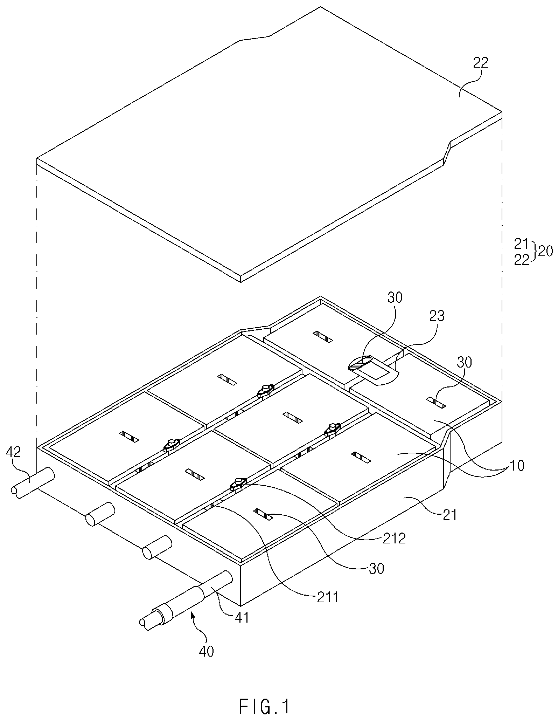

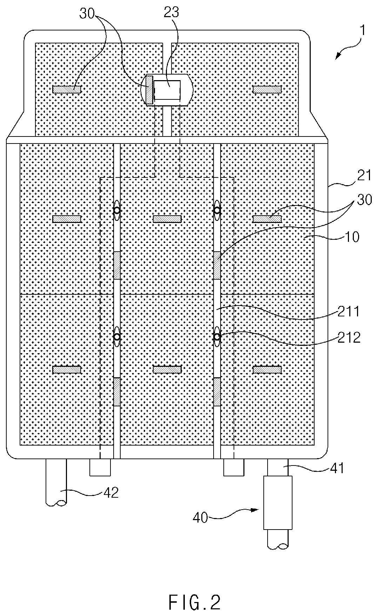

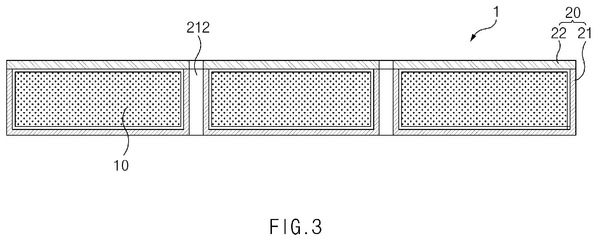

FIG. 1 is a perspective view of a battery back according to a first embodiment of the present invention, FIG. 2 is a cross-sectional view of FIG. 1, and FIG. 3 is a schematic plan view illustrating a position of a dew condensation detection sensor provided in the battery pack according to the first embodiment of the present invention.

A battery pack 1 according to the first embodiment of the present invention has a structure including a dew condensation detection sensor 30. Due to this structure, dew condensation generated inside the battery pack may be quickly detected, and as a result, danger may be detected or prevented at an early stage.

That is, the battery pack 1 according to the first embodiment of the present invention, as illustrated in FIGS. 1 to 3, includes a battery module 10, a pack housing 20 in which the battery module 10 is accommodated, and a dew condensation detection sensor 30 that detects the dew condensation generated inside the pack housing 20. Here, the dew condensation detection sensor 30 detects the dew condensation through an insulation abnormality signal generated inside the pack.

The dew condensation refers to a phenomenon in which moisture is formed as water droplets on a surface of an object when a temperature of air containing moisture falls below a dew point. That is, the water droplets is formed inside the battery pack to generate dew condensation due to a temperature difference between the inside and outside of the battery pack 1 according to the first embodiment of the present invention.

### Battery module

The battery module 10 has a structure in which a plurality of battery cells are connected in series and/or in parallel. Here, each of the battery cells includes an electrode assembly and a case in which the electrode assembly is accommodated, and the electrode assembly has a structure in which electrodes and separators are alternately arranged. The electrodes may be a positive electrode and a negative electrode.

### Pack housing

The pack housing 20 includes a pack case 21 having an accommodation space in which one or more battery modules 10, preferably two or more battery modules 10 are accommodated, and a pack cover 22 that opens and closes the accommodation space of the pack case 21.

Here, the accommodation space of the pack case 21 has a structure that is opened upward as illustrated in FIG. 2, and the pack cover 22 is coupled to an upper portion of the pack case 21 to open and close the accommodation space.

The pack case 21 is provided with a partition wall 211 that partitions the accommodation space in which the plurality of battery modules 10 are accommodated, and a support member 2121 that supports the pack cover 22 is provided on the partition wall 211. That is, the support member 212 serves to support a central portion of the pack cover 22 so as not to be pressed in a direction of the pack case 21.

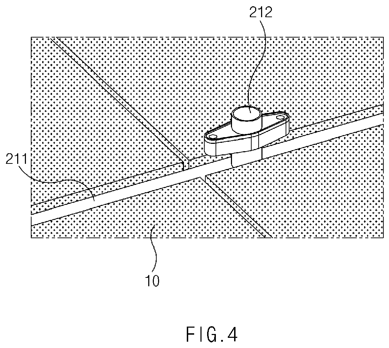

FIG. 4 is a perspective view illustrating the support member provided in the battery pack according to the first embodiment of the present invention.

Particularly, the support member 212 has a bolt hole 2121 penetrated vertically, as illustrated in FIG. 4. That is, the bolt hole 2121 serves as a passage through which the pack case 21 and the pack cover 22 are fixed using bolts and nuts.

The battery pack according to the related art has a problem in which dew condensation is generated inside the pack case 21 under high temperature and high humidity environments or when there is a large temperature difference between the inside and outside of the pack case.

The battery pack 1 according to the first embodiment of the present invention includes the dew condensation detection sensor 30 that detects the dew condensation generated inside the pack case 21.

### Dew condensation detection sensor

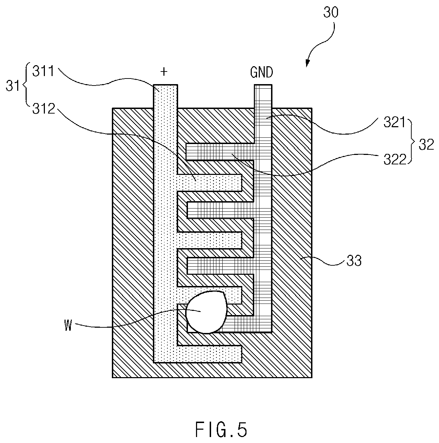

FIG. 5 is a plan view illustrating the dew condensation detection sensor of FIG. 1 according to the first embodiment of the present invention.

As illustrated in FIG. 5, the dew condensation detection sensor 30 is used to detect the dew condensation generated inside the pack housing 20. That is, the dew condensation detection sensor 30 is provided inside the pack case 21 and is connected by the dew condensation (i.e., water droplets W) generated inside the pack case 21 to generate an insulation abnormality signal, thereby detecting an occurrence of the dew condensation through the insulation abnormality signal.

For example, the dew condensation detection sensor 30 includes a first conductor 31 and a second conductor 32, which are connected by the dew condensation generated inside the pack case 21 to generate the insulation abnormality signal.

The first conductor 31 includes a first body 311 connected to a voltage line of the battery module 10 and a plurality of first terminals 312 protruding from the first body 311.

The second conductor 32 includes a second body 321 connected to a ground GND of the pack case 21 and a plurality of second terminals 322 protruding from the second body 321.

Here, the plurality of first terminals 312 and the plurality of second terminals 322 are alternately disposed and connected by the dew condensation to generate the insulation abnormality signal. That is, referring to FIG. 5, the water droplets W that is the dew condensation fall to the first terminal 312 and the second terminal 322 so that the first terminal 312 and the second terminal 322 are in contact with each other, and thus, the insulation abnormality signal is generated, and the dew condensation detection sensor 30 detects the occurrence of the dew condensation through the insulation abnormality signal.

Each of the first conductor 31 and the second conductor 32 may be made of copper or aluminum.

The dew condensation detection sensor 30 having the above-described configuration may quickly detect the dew condensation generated inside the pack housing 20, and as a result, an occurrence of danger may be detected and prevented at an early stage.

The first and second conductors 31 and 32 have a structure attached to a surface of an insulating film 33 to prevent the first and second conductors from being in unintentional contact with each other.

The dew condensation detection sensor 30 may be disposed at a portion of the inside of the pack case 21 at which a lot of dew condensation is generated.

As a first example, the dew condensation detection sensor 30 may be attached to the inside of the pack case corresponding to a top surface of the battery module 10, preferably a surface of the pack cover 22 corresponding to the top surface of the battery module 10. That is, due to heat generated from the battery module 10, a lot of dew condensation is generated on the surface of the pack cover 22 corresponding to the top surface of the battery module 10. Thus, the occurrence of the dew condensation may be quickly detected by attaching the dew condensation detection sensor 30 to the surface of the pack cover 22 corresponding to the top surface of the battery module 10.

As a second example, the dew condensation detection sensor 30 may be attached to the inside of the pack case that is close to the support member 212 provided in the pack case 21, preferably the surface of the pack cover 22 that is close to the support member 212 provided in the pack case 21. That is, the support member 212 causes a lot of dew condensation on the pack cover 22 on which the support member 212 is disposed due to external air introduced through the bolt hole 2121. Thus, the dew condensation may be quickly detected by attaching the dew condensation detection sensor 30 to the surface of the pack cover 22 that is close to the support member 212.

As a third example, a power cutoff device (manual service disconnect (MSD)) that cuts off power connected to the battery module 10 may be provided inside the pack case 21, and the dew condensation detection sensor 30 may be attached to the inside of the pack case that is close to the power cutoff device, preferably a surface of the pack cover 22 that is close to the power cutoff device 23. That is, a lot of dew condensation is generated on the pack cover 22 due to heat generated from the power cutoff device 23. Thus, the dew condensation may be quickly detected by attaching the dew condensation detection sensor 30 to the pack cover 22 that is close to the power cutoff device 23.

The power cutoff device 23 is a structure for disconnecting the voltage line of the battery module 10 accommodated inside the pack case 21 when inspecting the battery pack 1.

The dew condensation detection sensor 30 may be attached to the surface of the pack cover 22 using an adhesive 34 or an adhesive film.

The dew condensation detection sensor 30 may be fitted into and coupled to a hole defined in the pack cover 22 using a bracket. That is, after the dew condensation detection sensor 30 is coupled to the bracket, a coupling part provided on the bracket may be fitted into and coupled to the hole defined in the pack cover 22.

Therefore, according to the first embodiment of the present invention, the battery pack 1 may include the dew condensation detection sensor 30 to quickly detect the dew condensation generated inside the pack case 21, thereby preventing the occurrence of the danger through the cutoff of the power.

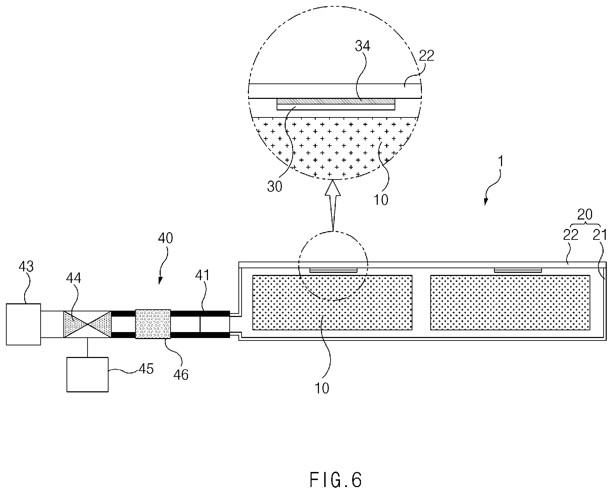

FIG. 6 is a cross-sectional view illustrating a dew condensation removing device of the battery pack according to the first embodiment of the present invention.

As illustrated in FIG. 6, the battery pack 1 according to the first embodiment of the present invention may further include a dew condensation removing device 40 that circulates air inside the pack case 21 to remove the dew condensation generated in the pack case 21.

### Dew condensation removing device

As illustrated in FIGS. 1 and 6, the dew condensation removing device 40 has a structure that removes the dew condensation generated in the pack case 21 by circulating air outside and inside the pack case 21.

That is, the dew condensation removing device 40 includes an injection tube 41 and a discharge tube 42, each of which is connected to the inside of the pack case 21, and an air generation part 43 that injects air into the pack case 21 through the injection tube 41 to forcibly discharge air inside the pack case 21 through the discharge tube 42.

That is, in the dew condensation removing device 40, when the dew condensation detection sensor 30 detects the dew condensation generated inside the pack case 21, the air generation part 43 operates to supply air to the injection tube 41, and thus, a pressure inside the pack case 21 increases by the air supplied through the injection tube 41 to forcibly discharge the air inside the pack case 21 through the discharge tube 42. Here, the dew condensation generated inside the pack case 21 is gradually evaporated to be removed by the air circulating or passing through the inside of the pack case 21.

Thus, the battery pack 1 according to the first embodiment of the present invention may include the dew condensation removing device 40 to quickly remove the dew condensation generated inside the pack case 21, and as a result, the occurrence of danger may be prevented to improve safely.

The dew condensation removing device 40 may further include a valve 44 that opens and closes the injection tube 41 and the discharge tube 42. The valve 44 may selectively open and close the injection tube 41 and the discharge tube 42.

In addition, the dew condensation removing device 40 may further include a control part 45 for opening the valve 44 only when the insulation abnormality signal is generated by the dew condensation detection sensor 30 and operating the air generation part 43 so that the air inside the pack case 21 is supplied or discharged. Thus, if the dew condensation is not generated inside the pack case 21, the injection tube 41 and the discharge tube 42 are closed through the valve 44 to prevent foreign substances from being introduced into the pack case 21. In addition, when the dew condensation is generated inside the pack case 21, the injection tube 41 and the discharge tube 42 are opened through the valve 44 so that the air inside the pack case 21 is circulated.

The dew condensation removing device 40 may further include a filter 46 for filtering the foreign substances contained in the air passing through the injection tube 41. The filter may effectively remove the foreign substances contained in the air.

Thus, the battery pack 1 according to the first embodiment of the present invention may further include the dew condensation removing device 40 to effectively remove the dew condensation generated inside the pack housing 20.

Hereinafter, in descriptions of another embodiment of the present invention, constituents having the same function as the above-mentioned embodiment have been given the same reference numeral in the drawings, and thus duplicated description will be omitted.

### [Vehicle according to second embodiment of the present invention]

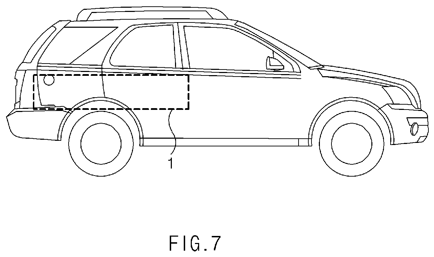

As illustrated in FIG. 7, a vehicle according to a second embodiment of the present invention has a structure including the battery pack 1 according to the first embodiment.

Here, the battery pack 1 includes a battery module 10, a pack case 21 in which the battery module 10 is accommodated and which is opened and closed by the pack cover 22, and a dew condensation detection sensor 30 that detects dew condensation through an insulation abnormality signal generated inside the pack case 21, and the dew condensation detection sensor 30 may include a first conductor 31 and a second conductor 32, which are connected by the dew condensation to generate the insulation abnormality signal.

Here, the battery pack 1 has the same configuration as the battery pack 1 according to the first embodiment, and thus duplicated descriptions will be omitted.

The vehicle according to the second embodiment of the present invention includes an air conditioning device that circulates air in an interior space in which the driver and assistant ride.

Here, the air conditioning device may be an air generation part 43 provided in the battery pack 1. That is, when the dew condensation is generated in the battery pack 1, some of the air generated by the air conditioning device is supplied to the inside of the pack case 21 of the battery pack 1. Thus, there is no need to provide a separate air generation part, thereby improving efficiency of use.

Therefore, the vehicle according to the second embodiment of the present invention may include the battery pack 1 to improve safety from explosion and ignition.

Accordingly, the scope of the present invention is defined by the appended claims more than the foregoing description and the exemplary embodiments described therein. Various modifications made within the meaning of an equivalent of the claims of the invention and within the claims are to be regarded to be in the scope of the present invention.

### [Description of the Symbols]

- 1:: Battery pack
- 10:: Battery module
- 20:: Pack housing
- 21:: Pack case
- 211:: Partition wall
- 212:: Support member
- 22:: Pack cover
- 23:: Power cutoff device
- 30:: Dew condensation detection sensor
- 31:: First conductor
- 311:: First body
- 312:: First terminal
- 32:: Second conductor
- 321:: Second body
- 322:: Second terminal
- 33:: Insulating film
- 34:: Adhesive
- 40:: Dew condensation removing device
- 41:: Injection tube
- 42:: Discharge tube
- 43:: Air generation part
- 44:: Valve
- 45:: Control part
- 46:: Filter

## Claims

1. A battery pack comprising:
a battery module;
a pack housing provided with a pack case, in which the battery module is accommodated, and a pack cover configured to open and close the pack case; and
a dew condensation detection sensor configured to detect dew condensation through an insulation abnormality signal generated inside the pack case,
wherein the dew condensation detection sensor comprises a first conductor and a second conductor connected to each other by the dew condensation generated inside the pack case to generate the insulation abnormality signal.

2. The battery pack of claim 1, wherein the first conductor comprises a first body connected to a voltage line of the battery module and a plurality of first terminals protruding from the first body, and
the second conductor comprises a second body connected to a ground of the pack case and a plurality of second terminals protruding from the second body,
wherein the plurality of first terminals and the plurality of second terminals are alternately disposed and connected to each other by the dew condensation to generate the insulation abnormality signal.

3. The battery pack of claim 1, wherein the dew condensation detection sensor is attached to a surface of the pack cover corresponding to a top surface of the battery module.

4. The battery pack of claim 1, wherein the battery module is provided in plurality,
the pack case comprises:
a partition wall configured to partition an accommodation space in which the plurality of battery modules are accommodated; and
a support member provided on the partition wall to support the pack cover, and
the dew condensation detection sensor is attached to a surface of the pack cover, which is close to the support member.

5. The battery pack of claim 1, wherein a power cutoff device (manual service disconnect (MSD)) that cuts off power connected to the battery module is provided inside the pack case, and
the dew condensation detection sensor is attached to a surface of the pack cover, which is close to the power cutoff device.

6. The battery pack of claim 1, wherein the dew condensation detection sensor is attached to the pack cover using an adhesive or an adhesive film.

7. The battery pack of claim 1, wherein the battery pack further comprises a dew condensation removing device configured to circulate air inside the pack case so as to remove the dew condensation generated inside the pack case.

8. The battery pack of claim 7, wherein the dew condensation removing device comprises:
an injection tube and a discharge tube, which are connected to the inside of the pack case; and
an air generation part configured to inject air into the pack case so as to discharge the air inside the pack case through the discharge tube.

9. The battery pack of claim 8, wherein the dew condensation removing device comprises:
a valve configured to open and close the injection tube and the discharge tube; and
a control part configured to open the valve only when the insulation abnormality signal is generated by the dew condensation detection sensor and discharge the air inside the pack case through the air generation part.

10. The battery pack of claim 8, wherein the dew condensation removing device further comprises a filter configured to filter foreign substances contained in the air passing through the injection tube.

11. The battery pack of claim 2, wherein each of the first conductor and the second conductor is made of copper or aluminum.

12. A vehicle comprising the battery pack of claim 1.
